# EUROPÄISCHE PATENTSCHRIFT

(11) **EP 3 736 050 B1**
(45) Veröffentlichungstag und Bekanntmachung des Hinweises auf die Patenterteilung: **16.11.2022**
(21) Anmeldenummer: 20173799.6
(22) Anmeldetag: 11.05.2020
(51) Int. Cl.: B05C 5/02, B05B 7/02, B41M 5/00, H01L 31/0224, H01L 21/67, B05C 11/06, B05C 11/10

(54) **VORRICHTUNG UND VERFAHREN ZUM AUFBRINGEN FLÜSSIGER MEDIEN AUF EINE SUBSTRATOBERFLÄCHE**
DEVICE AND METHOD FOR APPLYING LIQUID MEDIA TO A SUBSTRATE SURFACE
DISPOSITIF ET PROCÉDÉ D'APPLICATION DES MILIEUX LIQUIDES À UNE SURFACE DE SUBSTRAT

(30) Priorität: 09.05.2019 DE 102019206706
(43) Veröffentlichungstag der Anmeldung: 11.11.2020
(73) Patentinhaber: Fraunhofer-Gesellschaft zur Förderung der angewandten Forschung e.V., 80686 München (DE)
(72) Erfinder: Jahn, Mike, 79110 Freiburg (DE); Keding, Roman, 79110 Freiburg (DE)
(74) Vertreter: Friese Goeden Patentanwälte PartGmbB

(56) Entgegenhaltungen:
- EP-A1- 2 196 316
- WO-A1-2014/081051
- CN-B- 103 456 835
- US-A1- 2009 238 994
- US-A1- 2012 038 031
- US-A1- 2013 025 664
- US-A1- 2014 329 019

## Beschreibung

Die Erfindung betrifft eine Vorrichtung zum Aufbringen flüssiger Medien auf eine Substratoberfläche, enthaltend eine Fluidführungseinrichtung und zumindest eine Fluidfördereinrichtung und zumindest eine Vorschubeinrichtung zur Erzeugung einer Relativbewegung zumindest zwischen der Substratoberfläche und einem Teil der Fluidführungseinrichtung. Weiterhin betrifft die Erfindung ein Verfahren zum Aufbringen flüssiger Medien auf eine Substratoberfläche, bei welchem das flüssige Medium mit zumindest einer Fluidfördereinrichtung zu zumindest einer Fluidführungseinrichtung gefördert wird, wobei mit zumindest einer Vorschubeinrichtung eine Relativbewegung zumindest zwischen der Substratoberfläche und einem Teil der Fluidfördereinrichtung erzeugt wird. Vorrichtungen und Verfahren dieser Art können zur Herstellung von Leiterbahnen oder elektrischen Kontakten auf Halbleitersubstraten, zum lokalen Aufbringen eines Ätzmittels oder für generative Herstellungsverfahren verwendet werden.

Aus der Praxis ist bekannt, zur Erzeugung eines Vorderseitenkontaktes auf einer photovoltaischen Zelle eine Siebdruckpaste mit Metallpartikeln durch eine Dosiernadel auf der Oberfläche eines Halbleitersubstrates abzulegen und durch nachfolgendes Tempern einen ohmschen Kontakt auszubilden. Die hierfür verwendete Dosiernadel weist Durchmesser von mehr als 60 µm auf, sodass auch die kleinste hiermit erzielbare Strukturgröße des Vorderseitenkontaktes nicht geringer sein kann. Darüber hinaus sind die erzielbaren Übergangswiderstände oftmals zu hoch und der Kontakt dadurch unzulänglich.

Aus der US 2012/038031 A1 ist bekannt, Materialien, welche Flüssigkeit enthalten, in Rillen auf einer Oberfläche eines Siliziumwafers abzuscheiden, um eine Solarzelle zu bilden. Die Flüssigkeit kann durch ein Rohr in die Rillen abgegeben werden. Hierbei läuft das Rohr mechanisch geführt in der Nut.

Die US 2013/0025664 A1 betrifft eine Paste zur Bildung einer Solarzellenelektrode, umfassend elektrisch leitende Metallpartikel, Glasfritte, ein vernetzbares Mittel, einen Photopolymerisationsinitiator und ein organisches Lösungsmittel.

Ausgehend vom Stand der Technik liegt der Erfindung somit die Aufgabe zugrunde, Strukturen mit kleinen Abmessungen mit hoher Zuverlässigkeit und kurzen Bearbeitungszeiten auf Substratoberflächen zu erzeugen.

Die Aufgabe wird erfindungsgemäß durch eine Vorrichtung gemäß Anspruch 1, deren Verwendung nach Anspruch 9 und ein Verfahren nach Anspruch 10 gelöst. Vorteilhafte Weiterbildungen der Erfindung finden sich in den Unteransprüchen.

Erfindungsgemäß wird eine Vorrichtung zum Aufbringen flüssiger Medien vorgeschlagen, welche eine Fluidführungseinrichtung enthält. Die Fluidführungseinrichtung kann in einigen Ausführungsformen der Erfindung eine Kapillare aus Glas oder Quartz oder Kunststoff sein oder eine solche Kapillare enthalten. Die Kapillare kann zumindest in einem Teilabschnitt biegsam sein, sodass diese bei Betrieb der Vorrichtung auf der Substratoberfläche aufgesetzt werden kann. Daneben kann die Fluidführungseinrichtung in an sich bekannter Weise ein Schlauchsystem beziehungsweise ein Rohrsystem zur Zufuhr des flüssigen Mediums enthalten. Erfindungsgemäß wird somit vorgeschlagen, ein flüssiges Medium durch eine oder mehrere Kapillaren auf eine Substratoberfläche aufzubringen. Das zum Austritt des flüssigen Mediums bestimmte offene Ende der Kapillare wird dabei gleitend auf der Substratoberfläche geführt.

Der Außendurchmesser der Kapillare kann in zumindest einem Teilabschnitt an dem der Substratoberfläche zugewandten Ende bzw. an der mit der Substratoberfläche in Kontakt stehenden Öffnung geringer sein als etwa 25 µm oder etwa 15 µm oder etwa 10 µm oder etwa 7 µm. Erfindungsgemäß wurde erkannt, dass der Außendurchmesser der Kapillare die Strukturbreite des auf der Substratoberfläche abgelegten Strangs des flüssigen Mediums beeinflusst, sodass mit den offenbarten Kapillaren auch kleine Strukturen erzeugbar sind. Der Außendurchmesser der Kapillare kann in zumindest einem Teilabschnitt an dem der Substratoberfläche zugewanden Ende bzw. an der mit der Substratoberfläche in Kontakt stehenden Öffnung einen Außendurchmesser aufweisen, welcher größer ist als etwa 1 µm oder größer ist als etwa 3 µm oder größer ist als etwa 5 µm.

In einigen Ausführungsformen der Erfindung kann die Kapillare einen ersten Längsabschnitt aufweisen, welcher gegenüber einem zweiten Längsabschnitt der Kapillare angewinkelt bzw. gebogen ist. Der erste und der zweite Längsabschnitt können einen Winkel von etwa 170° bis etwa 100° oder von etwa 160° bis etwa 110° oder von etwa 150° bis etwa 120° einschließen. In anderen Ausführungsformen der Erfindung kann die Kapillare gerade sein, d.h. der erste und der zweite Längsabschnitt schließen einen Winkel von etwa 180° ein. In diesem Fall kann die Kapillare in der Vorrichtung geneigt eingebaut sein, so dass diese zumindest im Betrieb der Vorrichtung einen Winkel von etwa 80° bis etwa 10° oder von etwa 70° bis etwa 20° oder von etwa 30° bis etwa 45° oder von etwa 20° bis etwa 10° zum Normalenvektor der Substratoberfläche einschließt. Dies reduziert die Beschädigung der in Kontakt mit der Kapillare stehenden Substratoberfläche und/oder kann die Bruchgefahr der Kapillare reduzieren.

Zur Zufuhr des flüssigen Mediums in die Fluidführungseinrichtung dient zumindest eine Fluidfördereinrichtung, welche das flüssige Medium mit konstantem Druck und/oder konstanter Durchflussrate in die Fluidführungseinrichtung und nachfolgend auf die Substratoberfläche fördert.

Erfindungsgemäß ist keine vollflächige Beschichtung der Substratoberfläche mit dem flüssigen Medium vorgesehen, sondern das Aufbringen einer Teilbeschichtung beziehungsweise einer Beschichtung, welche nur eine Teilfläche der Substratoberfläche belegt. Die beschichteten Teilflächen können eine oder mehrere gerade oder gekrümmte Linien bilden. Diese können in konstantem Abstand nebeneinander verlaufen und/oder sich mit weiteren Linien kreuzen. Eine einzelne Linie bzw. Teilfläche kann eine Breite von etwa 50 µm bis etwa 2 µm oder von etwa 30 µm bis etwa 2 µm oder etwa 15 µm bis etwa 4 µm aufweisen. In anderen Ausführungsformen der Erfindung kann die mit dem flüssigen Medium beschichtete Teilfläche kreis- bzw. punktförmig sein oder eine Mehrzahl von Einzelpunkten entlang einer Linie aufweisen.

Zur Erzeugung einer ausgedehnten Teilfläche bzw. Linie weist die erfindungsgemäße Vorrichtung zumindest eine Vorschubeinrichtung auf, welche der Erzeugung einer Relativbewegung zwischen zumindest einem Teil der Fluidführungseinrichtung und der Substratoberfläche dient. In einigen Ausführungsformen der Erfindung kann die Vorschubeinrichtung einen Linearantrieb enthalten oder daraus bestehen. In diesem Fall kann die Vorrichtung zum Aufbringen flüssiger Medien Punktfolgen oder durchgehende oder unterbrochene Linien erzeugen. Eine Mehrzahl paralleler Linien kann durch mehrere, parallel angeordnete Fluidführungseinrichtung erzeugt werden.

In einigen Ausführungsformen der Erfindung kann die Vorschubeinrichtung einen x-y-Tisch enthalten oder daraus bestehen, sodass das Substrat unter einer statischen Fluidführungseinrichtung in zwei Richtungen bewegbar ist. Die Bewegung in zwei Achsen erlaubt das Aufbringen einer Mehrzahl paralleler Linien mit einer Fluidführungseinrichtung oder auch die Erzeugung gekrümmter oder gitterförmiger Linien. Alternativ oder zusätzlich kann die Vorschubeinrichtung auch eine Rotation um zumindest eine Achse ermöglichen, beispielsweise um die Normalenrichtung der durch den x-y-Tisch aufgespannten Ebene. Somit können in einfacher Weise runde oder spiralförmige Linien oder auch gerade Linien in unterschiedlichen Richtungen erzeugt werden.

Erfindungsgemäß kommt es lediglich auf eine relative Bewegung zwischen der Substratoberfläche und zumindest einem Teil der Fluidfördereinrichtung an. Daher kann selbstverständlich auch das Substrat ortsfest gelagert werden, wenn die Vorschubeinrichtung dazu eingerichtet ist, die gesamte Fluidführungseinrichtung oder zumindest einen Teil der Fluidführungseinrichtung zu bewegen. In einigen Ausführungsformen der Erfindung ist die Vorschubeinrichtung dazu eingerichtet, eine relative Bewegung zwischen dem Substrat und der Fluidführungseinrichtung beziehungsweise einem Teil der Fluidführungseinrichtung innerhalb der durch das Substrat definierten Ebene zu ermöglichen.

Das Substrat kann in einigen Ausführungsformen der Erfindung ein Halbleitermaterial sein, welches mit elektrischen Kontakten versehen wird. In einigen Ausführungsformen der Erfindung kann das Halbleitersubstrat eine photovoltaische Zelle sein, welche mit einem Vorderseiten- oder einem Rückseitenkontakt versehen wird. In anderen Ausführungsformen der Erfindung kann das Substrat ein Metall, eine Legierung oder ein Halbleitermaterial enthalten, auf welches lokal ätzende Medien aufgebracht werden, um auf diese Weise Strukturen in der Substratoberfläche zu erzeugen. In wiederum anderen Ausführungsformen der Erfindung kann das flüssige Medium ein explosives Medium, ein pyrophores Medium und/oder ein Medium mit niedrigem Dampfdruck sein. In diesen Fällen ermöglicht die erfindungsgemäße Vorrichtung beispielsweise eine Solarzellenproduktion unter Verwendung von Silanen, insbesondere Monosilan. In wiederum anderen Ausführungsformen ermöglicht die Erfindung die Herstellung von Verbindungshalbleitern, beispielsweise unter Verwendung von Monophosphan oder anderen, schwer handhabbaren Precursoren.

In wiederum anderen Ausführungsformen der Erfindung kann das flüssige Medium Nanopartikel enthalten, beispielsweise Partikel aus einem Metall oder einer Legierung, welche nach Verdampfen eines flüssigen Lösungsmittels und einem optionalen Sinter- oder Temperschritt elektrisch leitfähige Strukturen ausbilden. In wiederum anderen Ausführungsformen der Erfindung kann das flüssige Medium lebende Zellen enthalten, welche in einem 3D-Druckverfahren zu größeren Organismen und/oder Organen zusammengesetzt werden können. Alternativ können lebende Zellen zur Durchführung biologischer Experimente mit hoher Genauigkeit auf einem Objektträger oder einem Lab-on-Chip abgelegt werden.

In einigen Ausführungsformen der Erfindung kann die Vorrichtung weiterhin zumindest eine Antriebseinrichtung zur Veränderung des Abstandes zwischen der Substratoberfläche und einem Teil eines zweiten Längsabschnittes der Fluidführungseinrichtung enthalten. Die Antriebseinrichtung ist dazu vorgesehen, einerseits eine Beschädigung der Kapillare der Fluidführungseinrichtung zu vermeiden und andererseits eine Beschädigung der Substratoberfläche durch hartes Aufsetzen der Fluidführungseinrichtung zu vermeiden. Hierzu ist eine Antriebseinrichtung vorgesehen, welche den Abstand mit hoher Genauigkeit und hoher Regelgeschwindigkeit einstellen kann. Hierdurch wird ermöglicht, dass der mit der Substratoberfläche in Kontakt stehende Längsabschnitt der Fluidführungseinrichtung, z.B. das Ende einer Glaskapillare, entweder in geringem Abstand über der Substratoberfläche geführt wird oder aber die Glaskapillare in Kontakt mit der Substratoberfläche mit geringer Anpresskraft gleitet, sodass eine Beschädigung der Substratoberfläche und der Kapillare vermieden wird. Weiterhin dient das Einhalten eines konstanten Abstandes bzw. eines konstanten Anpressdruckes dazu, eine Linie konstanter Breite zu erzeugen.

In einigen Ausführungsformen der Erfindung kann eine Einrichtung zur Abstandserfassung vorhanden sein, welche den Abstand zwischen der Substratoberfläche und einem Teil eines zweiten Längsabschnittes der Fluidführungseinrichtung bestimmt. Hierzu kann eine optische Abstandsmessung erfolgen, beispielweise durch Bildverarbeitung eines Mikroskopbildes oder durch Laserinterferenz. In anderen Ausführungsformen der Erfindung kann die Anpresskraft zwischen der Substratoberfläche und der Fluidführungseinrichtung als Maß für den Abstand beider Bauteile herangezogen werden. Der so erfasste Ist-Wert des Abstandes kann mit einem vorgebbaren Soll-Wert verglichen und zur Regelung der Antriebseinrichtung verwendet werden.

In einigen Ausführungsformen der Erfindung kann die Antriebseinrichtung zumindest einen Piezosteller enthalten oder daraus bestehen. Eine solche Antriebseinrichtung ermöglicht eine rasche Verstellung, sodass auch bei hoher Vorschubgeschwindigkeit der Abstand zwischen der Fluidführungseinrichtung und der Substratoberfläche gesteuert oder geregelt werden kann, ohne unzulässig hohe Kräfte auf die Substratoberfläche aufzubringen dadurch die Fluidführungseinrichtung oder die Substratoberfläche zu beschädigen.

In einigen Ausführungsformen der Erfindung kann die Antriebseinrichtung einen Stellweg von etwa 100 µm bis etwa 300 µm oder von etwa 150 µm bis etwa 250 µm oder von etwa 180 µm bis etwa 220 µm ermöglichen. Dieser Stellweg reicht aus, um unerwünschte Kollisionen der Fluidfördereinrichtung mit der Substratoberfläche zu verhindern, sodass eine Beschädigung des Substrates oder der Fluidführungseinrichtung vermieden wird.

In einigen Ausführungsformen der Erfindung kann die Antriebseinrichtung dazu eingerichtet sein, den Stellweg mit einer Frequenz von etwa 200 Hz bis etwa 2000 Hz oder von etwa 500 Hz bis etwa 1500 Hz oder von etwa 800 Hz bis etwa 1200 Hz zu durchfahren. Eine hohe Stellgeschwindigkeit der Antriebseinrichtung ermöglicht den Ausgleich von Unebenheiten auf der Substratoberfläche und/oder das Aufsetzen und Anheben der Fluidführungseinrichtung von der Substratoberfläche auch bei hohen Vorschubgeschwindigkeiten der Vorschubeinrichtung, sodass die Bearbeitungsgeschwindigkeit beim Aufbringen flüssiger Medien erhöht sein kann.

In einigen Ausführungsformen der Erfindung kann die Fluidführungseinrichtung zumindest einen zweiten Längsabschnitt aufweisen, welcher einen Innendurchmesser von etwa 0,5 µm bis etwa 10 µm oder von etwa 2 µm bis etwa 8 µm oder von etwa 4 µm bis etwa 6 µm aufweist. Dieser zweite Längsabschnitt ist dazu eingerichtet und bestimmt, das distale Ende der Fluidführungseinrichtung zu bilden und damit diejenige Öffnung zu definieren, durch welche das flüssige Medium auf die Substratoberfläche aufgebracht wird. Da der Durchmesser somit etwa einen Faktor 6 bis 10 geringer ist als bei bekannten Dosiernadeln, können die mit der erfindungsgemäßen Vorrichtung erzeugten Strukturen auf der Substratoberfläche ebenfalls einen Faktor 5 bis 10 geringer sein.

In einigen Ausführungsformen der Erfindung kann die Fluidfördereinrichtung eine Exzenterschneckenpumpe oder eine Kolbenpumpe oder eine Spritzenpumpe enthalten oder daraus bestehen. Diese Fluidfördereinrichtungen lassen sich in Durchfluss und Druck präzise regeln, sodass die Fördermenge des flüssigen Mediums durch die Fluidführungseinrichtung präzise kontrollierbar ist und dadurch auch die erzeugten Strukturen in Breite und/oder Längsausdehnung präzise kontrollierbar sind.

Erfindungsgemäß ist die Fluidfördereinrichtung dazu eingerichtet, das flüssige Medium mit einem Druck von etwa 100 mbar bis etwa 500 mbar oder von etwa 150 mbar bis etwa 300 mbar oder von etwa 500 mbar bis etwa 5000 mbar oder von etwa 1000 mbar bis etwa 2000 mbar von etwa 0 mbar bis etwa 100 mbar zu fördern. Die genannten Druckbereiche ermöglichen einerseits, auch flüssige Medien, welche beispielsweise Nanopartikel enthalten und hierdurch eine höhere Viskosität aufweisen, zuverlässig durch eine dünne Fluidführungseinrichtung zu fördern. Andererseits sind die Drücke gering genug, um beispielsweise lebende Zellen bei der Applikation auf der Substratoberfläche nicht zu zerstören.

In einigen Ausführungsformen der Erfindung kann die Vorschubeinrichtung dazu eingerichtet sein, mit einer Vorschubgeschwindigkeit von etwa 100 mm/s bis etwa 1000 mm/s oder von etwa 300 mm/s bis etwa 900 mm/s oder von etwa 500 mm/s bis etwa 800 mm/s betrieben zu werden. Dies erlaubt eine rasche Fertigung insbesondere geradliniger Strukturen mit der erfindungsgemäßen Vorrichtung, sodass Massenartikel wie beispielsweise Solarzellen insbesondere bei paralleler Aufbringung der Vorderseitenkontakte mit einer Mehrzahl von Fluidführungseinrichtungen mit einem Durchsatz bis 23000 Wafer pro Stunde prozessiert werden können. Damit hat sich überraschend gezeigt, dass das auf den ersten Blick sehr aufwendig erscheinende Verfahren gleichwohl einen hohen Durchsatz erlaubt, sodass die erfindungsgemäße Vorrichtung und das erfindungsgemäße Verfahren das Potenzial haben, üblichen Sieb- oder Tampondruck bei der Herstellung von Solarzellen abzulösen, bei gleichzeitig sinkenden Strukturgrößen der Vorderseitenkontakte.

In einigen Ausführungsformen der Erfindung enthält die Vorrichtung weiterhin ein Ventil zur Regelung des Volumenstroms des aus der Fluidführungseinrichtung austretenden flüssigen Mediums. Diese Ausführungsform der Erfindung erlaubt es, das aufzubringende flüssige Medium mittels der Fluidfördereinrichtung mit kontantem Druck zu beaufschlagen und den Volumenstrom allein durch das Öffnen und schließen eines Ventils zu steuern bzw. zu regeln. Hierdurch kann ein schnelles Regelverhalten erreicht werden, was die Toleranzen der Strukturbreite reduziert und/oder das An- und Absetzen am Anfang und Ende eines Substrates, beispielsweise eines Wafers, weiter beschleunigt.

In einigen Ausführungsformen der Erfindung kann die Vorrichtung weiterhin eine Intergaszufuhreinrichtung enthalten. In diesem Fall können auch sensible Medien, beispielsweise Stoffe, die zur Selbstentzündung neigen oder an Luft rasch oxidieren verarbeitet werden.

In einigen Ausführungsformen der Erfindung kann die Intergaszufuhreinrichtung einer Zufuhrleitung aufweisen, welche die Fluidführungseinrichtung konzentrisch umgibt. Weiterhin kann die Intergaszufuhreinrichtung eine optionale Abfuhrleitung aufweisen, welche die Zufuhrleitung konzentrisch umgibt. Hierdurch ist es möglich, nicht nur ein Inertgas zuzuführen, sondern auch das Inertgas und/oder Bestandteile des flüssigen Mediums über die Abfuhrleitung abzusaugen, sodass sich die Vorrichtung auch für die Verarbeitung toxischer Medien eignen kann.

In einigen Ausführungsformen der Erfindung kann die Intergaszufuhreinrichtung eine Heizeinrichtung enthalten, mit welcher das zugeführte Inertgas erwärmbar ist.

In einigen Ausführungsformen der Erfindung kann das flüssige Medium eine Viskosität von etwa 5 mPa·s bis etwa 200 mPa·s oder von etwa 5 mPa·s bis etwa 20 mPa·s aufweisen. Diese Medien lassen sich auch durch Fluidführungsvorrichtungen mit kleinem Innendurchmesser fördern.

In einigen Ausführungsformen der Erfindung kann das flüssige Medium metallische Nanopartikel mit einer Konzentration von etwa 2 Vol.-% bis etwa 10 Vol.-% oder von etwa 2 Vol.-% bis etwa 6 Vol.-% oder von etwa 3 Vol.-% bis etwa 5 Vol.-% enthalten. Beispielsweise kann das flüssige Medium eine leitfähige InkJet-Tinte sein, mit welcher leitfähige Strukturen wie beispielsweise Vorderseitenkontakte auf photovoltaischen Zellen in einem Tintenstrahldruckverfahren aufgebracht werden können. Anders als bei der Verarbeitung im Tintenstrahldruckverfahren wird das flüssige Medium erfindungsgemäß jedoch stetig gefördert und nicht in Form einzelner Tropfen aufgebracht. Hierdurch können die erfindungsgemäß hergestellten Strukturen wesentlich feiner sein und beispielsweise Breitenausdehnungen quer zur Vorschubgeschwindigkeit von etwa 2 µm bis etwa 10 µm aufweisen. Durch den kontinuierlichen Materialfluss wird darüber hinaus vermieden, dass sich zwischen einzelnen Tröpfchen unzulässig große Übergangswiderstände ausbilden, sodass die erfindungsgemäß hergestellten leitfähigen Kontakte eine erhöhte Leitfähigkeit beziehungsweise einen geringen ohmschen Widerstand aufweisen können.

In einigen Ausführungsformen der Erfindung erfolgt beim Aufsetzen der Fluidführungseinrichtung auf die Substratoberfläche eine Relativbewegung zwischen der Fluidführungseinrichtung und der Substratoberfläche. Hierdurch wird vermieden, dass durch einen harten Anprall der Fluidführungseinrichtung auf das Substrat die Substratoberfläche und/oder die Fluidführungseinrichtung beschädigt wird.

Nachfolgend soll die Erfindung anhand von Figuren ohne Beschränkung des allgemeinen Erfindungsgedankens näher erläutert werden. Dabei zeigt
Figur 1 Fluidführungseinrichtungen auf einem Substrat.
Figur 2 zeigt einen Ausschnitt aus Figur 1.
Figur 3 zeigt eine Vorrichtung zum Aufbringen flüssiger Medien in einer ersten Ausführungsform.
Figur 4 zeigt eine Vorrichtung zum Aufbringen flüssiger Medien in einer zweiten Ausführungsform.
Figur 5 zeigt eine Vorrichtung zum Aufbringen flüssiger Medien in einer dritten Ausführungsform.
Figur 6 zeigt eine Vorrichtung zum Aufbringen flüssiger Medien in einer vierten Ausführungsform.
Figur 7 zeigt eine Vorrichtung zum Aufbringen flüssiger Medien mit einer Intergaszufuhreinrichtung in einer ersten Ausführungsform.
Figur 8 zeigt eine Intergaszufuhreinrichtung in einer zweiten Ausführungsform.
Figur 9 zeigt eine Fluidführungseinrichtung mit Antriebseinrichtung in einer ersten Ausführungsform.
Figur 10 zeigt einen Ausschnitt aus Figur 9.
Figur 11 zeigt eine Fluidführungseinrichtung mit Antriebseinrichtung in einer zweiten Ausführungsform.
Figur 12 zeigt einen Ausschnitt aus Figur 11.

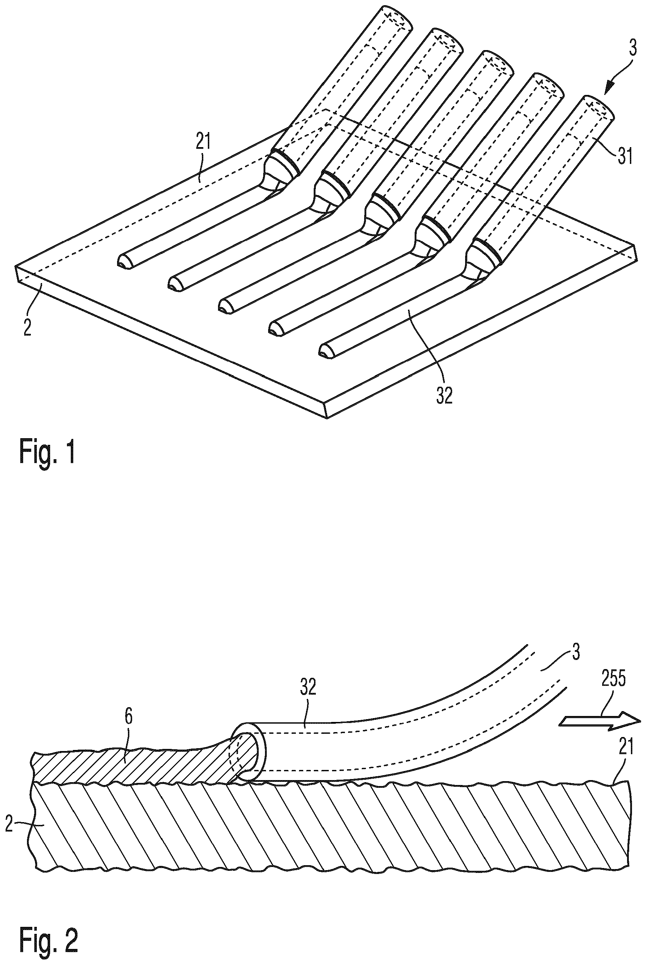

Anhand der Figuren 1 und 2 werden Fluidführungseinrichtungen erläutert, welche zum Aufbringen flüssiger Medien verwendbar sind. Dabei zeigt Figur 1 eine Mehrzahl parallel angeordneter Fluidführungseinrichtungen auf einem Substrat 2 und Figur 2 zeigt einen Ausschnitt einer einzelnen Fluidführungseinrichtung im Betrieb.

Die Figuren zeigen ein Substrat 2 mit einer Substratoberfläche 21. Das Substrat 2 kann beispielsweise ein Halbleitermaterial sein, wie zum Beispiel eine photovoltaische Zelle, welche mit einem Vorderseitenkontakt versehen werden soll. Zum Aufbringen der Vorderseitenkontakte aus einer mit metallischen Nanopartikeln gefüllten leitfähigen Tinte wird die erfindungsgemäße Vorrichtung mit einer Mehrzahl von Fluidführungseinrichtungen 3 verwendet. Im dargestellten Ausführungsbeispiel sind fünf parallel angeordnete Fluidführungseinrichtungen vorgesehen. In anderen Ausführungsformen der Erfindung kann die Anzahl der Fluidführungseinrichtungen auch größer oder geringer sein und beispielsweise zwischen eins und etwa fünfzig betragen. Hierdurch kann eine Mehrzahl paralleler Linien gleichzeitig auf das Substrat 2 aufgebracht werden, wodurch sich die Bearbeitungszeit reduziert.

Wie Figur 1 weiter zeigt, weist die Fluidführungseinrichtung 3 zumindest einen ersten Längsabschnitt 31 auf, welcher einen vergleichsweise großen Durchmesser hat und dadurch eine höhere mechanische Stabilität besitzt sowie einen zweiten Längsabschnitt 32, welcher aufgrund seines geringeren Durchmessers eine geringere mechanische Stabilität aufweist. Der zweite Längsabschnitt 32 ist stromabwärts des ersten Längsabschnittes 31 angeordnet. Der zweite Längsabschnitt 32 kann zumindest abschnittsweise einen Innendurchmesser von etwa 0,5 µm bis etwa 10 µm oder von etwa 2 µm bis etwa 8 µm oder von etwa 4 µm bis etwa 6 µm aufweisen. Der Außendurchmesser ist um die Wandstärke des zweiten Längsabschnittes vergrößert, welche zwischen etwa 1 µm bis eta 4 µm beträgt. Hierdurch definiert der Außendurchmesser des zweiten Längsabschnitt 32 die Breite der erzeugten Strukturen. Dieser Teil der Fluidführungseinrichtung kann aus einer Glaskapillare gebildet werden bzw. eine Glaskapillare enthalten.

Wie Figur 2 weiter zeigt, steht der zweite Längsabschnitt 32 mechanisch im Kontakt mit der Substratoberfläche 21, wodurch in Abhängigkeit von Abstand und Anpresskraft eine Biegung der Fluidführungseinrichtung 3 an deren distalen Ende vorliegen kann. Zwischen der Fluidführungseinrichtung 3 und dem Substrat 2 wird durch eine nicht dargestellte Vorschubeinrichtung eine Relativbewegung 255 erzeugt. Bei gleichzeitigem Fördern des flüssigen Mediums 6 durch die Fluidfördereinrichtung wird das flüssige Medium 6 in einer Linie auf der Substratoberfläche 21 abgelegt. Soweit es sich hierbei um eine leitfähig gefüllte Tinte handelt, kann der so erzeugte Vorderseitenkontakt durch nachträgliches Tempern mechanisch stabilisiert und/oder elektrisch aktiviert werden.

Es wurde erkannt, dass sich an der Öffnung der Fluidfördereinrichtung unter konstantem Druck des flüssigen Mediums 6 ein Tropfen bildet, welcher den weiteren Austritt des flüssigen Mediums aus der Fluidfördereinrichtung 3 verhindert, so lange diese nicht in Kontakt mit der Substratoberfläche 21 steht. Beim Aufsetzen des zweiten Längsabschnittes 32 der Fluidfördereinrichtung 3 auf die Substratoberfläche 21 startet der Flüssigkeitsstrom bei konstantem Druck selbsttätig, wenn die Oberflächenenergie der Substratoberfläche 21 höher ist als die Oberflächenenergie der Oberfläche der des zweiten Längsabschnittes 32 der Fluidfördereinrichtung 3. Beispielsweise kann das flüssige Medium eine wässrige Lösung oder Suspension sein, wenn die Substratoberfläche 21 hydrophil ist und zumindest der zweite Längsabschnitt 32 der Fluidfördereinrichtung 3 hydrophob ist. In diesem Fall kann der auf das Substrat aufgebrachte Strom allein durch den Abstand bzw. den Anpressdruck des zweiten Längsabschnittes 32 der Fluidfördereinrichtung 3 auf der Substratoberfläche 21 gesteuert bzw. geregelt werden. Bei unpolaren Flüssigkeiten können die jeweiligen Oberflächenenergien entsprechend gewählt werden.

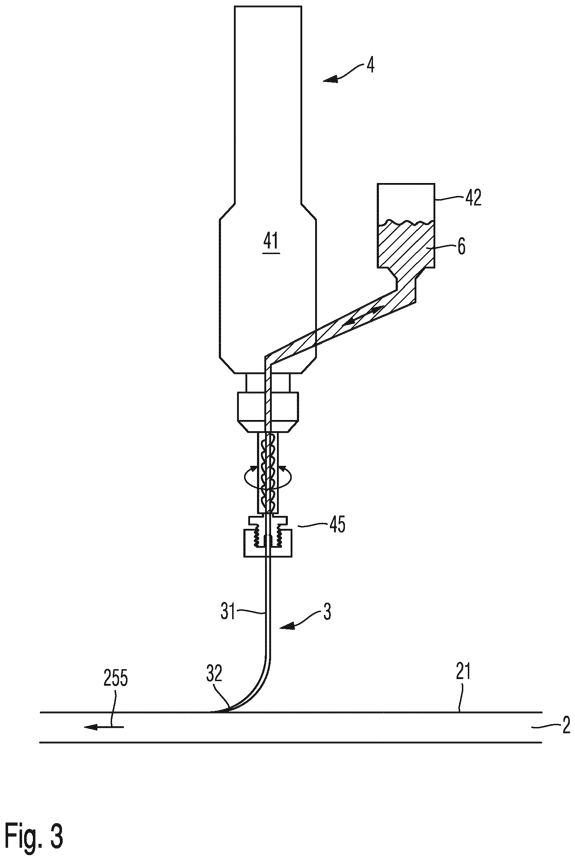

Figur 3 zeigt eine erste Ausführungsform der erfindungsgemäßen Vorrichtung. Dargestellt ist wiederum ein Substrat 2 mit einer Substratoberfläche 21, auf welche ein flüssiges Medium 6 aufgebracht werden soll. Hierzu steht, wie vorstehend in Verbindung mit Figur 1 und 2 beschrieben, die Fluidführungseinrichtung 3 zur Verfügung, welche mit ihrem zweiten Längsabschnitt 32 im Kontakt mit der Substratoberfläche 21 steht. Die Fluidführungseinrichtung 3 kann in einigen Ausführungsformen der Erfindung aus Glas oder Kunststoff bestehen und ist aufgrund ihres geringen Außendurchmessers mechanisch biegsam, sodass sich die in Figur 3 und Figur 2 gezeigte Form aufgrund der Relativbewegung 255 ausbildet.

Die in Figur 3 gezeigte Vorrichtung zeigt weiterhin eine Fluidfördereinrichtung 4 welche im dargestellten Ausführungsbeispiel als Exzenterschneckenpumpe 41 ausgeführt ist. Die Exzenterschneckenpumpe 41 enthält darüber hinaus ein Reservoir 42, in welchem das flüssige Medium 6 aufgenommen ist. Das flüssige Medium 6 wird durch die Exzenterschneckenpumpe 41 mit vorgebbarer Menge und/oder vorgebbarem Druck zur Fluidführungseinrichtung 3 gefördert. Zur Verbindung der Fluidführungseinrichtung 3 mit der Exzenterschneckenpumpe 41 steht ein Anschlusselement 45 zur Verfügung. Das Anschlusselement 45 kann beispielsweise eine Quetschverschraubung oder ein Luer-Anschluss sein.

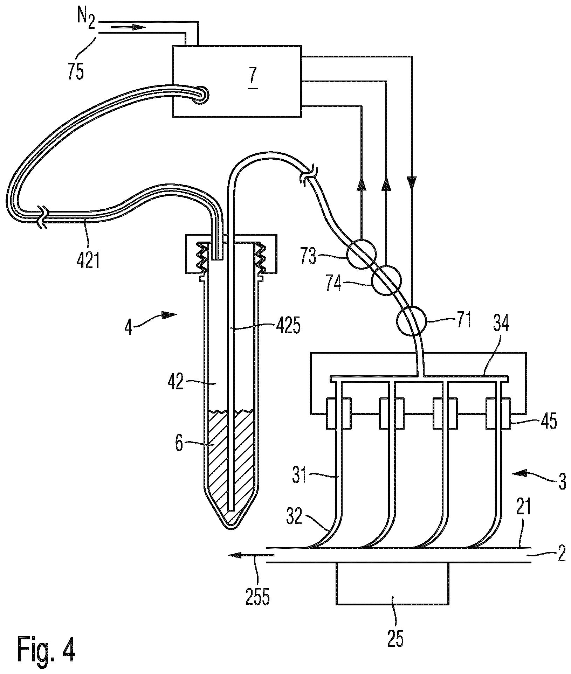

Anhand von Figur 4 wird eine zweite Ausführungsform der erfindungsgemäßen Vorrichtung erläutert. Gleiche Bestandteile der Erfindung sind mit gleichen Bezugszeichen versehen, sodass sich die nachfolgende Beschreibung auf die wesentlichen Unterschiede beschränkt.

Wie Figur 4 zeigt, ist das Substrat 2 auf einer Vorschubeinrichtung 25 montiert, welche in Form eines x-y-Tisches mit einer optionalen Rotationsmöglichkeit des Substrates 2 in der durch das Substrat aufgespannten Ebene eine Vorschubgeschwindigkeit 255 erzeugt. Hierdurch kann das Substrat relativ zur Fluidführungseinrichtung 3 bewegt werden, um so bei konstanter Förderung des flüssigen Mediums durch die Fluidfördereinrichtung 4 Linien konstanter Breite zu Erzeugen. Sofern die Fördermenge und/oder die Vorschubgeschwindigkeit 255 zeitlich variiert, können Linien unterschiedlicher Breite bzw. Taper erzeugt werden. Wie vorstehend beschrieben wurde, kann der Austritt des flüssigen Mediums 6 aus der Fluidführungsvorrichtung 3 dadurch kontrolliert werden, dass das zweite Ende 32 der Fluidführungsvorrichtung 3 mit der Substratoberfläche 6 in Kontakt gebracht wird. Somit können in einigen Ausführungsformen der Erfindung mehrere, auf einem Stetigförderer, wie zum Beispiel einem Förderband, unter der Fluidführungsvorrichtung 3 hindurch transportierte Substrate durch einfaches Anheben und Absenken der Fluidführungsvorrichtung 3 bei konstantem Druck des Flüssigen Mediums 6 im Reservoir 42 beschichtet werden.

Figur 4 zeigt, wie mit vier Fluidführungseinrichtungen 3 vier parallele beziehungsweise konzentrische Linien erzeugt werden können. Um eine gleichmäßige Zufuhr des flüssigen Mediums zu ermöglichen, sind die Fluidführungseinrichtungen 3 durch eine gemeinsame Leitung 34 miteinander verbunden.

Der weitere Unterschied der in Figur 4 gezeigten zweiten Ausführungsform gegenüber der vorstehend beschriebenen ersten Ausführungsform besteht in der Art der verwendeten Fluidfördereinrichtung 4. Auch die Fluidfördereinrichtung 4 gemäß der zweiten Ausführungsform weist eine Reservoir 42 auf, welches mit dem flüssigen Medium 6 gefüllt ist. Das Reservoir 42 wird über eine Leitung 421 mit einem konstanten Gasdruck beaufschlagt. Der Druck wird über eine Steuer- oder Regeleinrichtung 7 erzeugt, welche entweder einen Druckminderer enthält, um ein zugeführtes Druckgas auf ein vorgebbares, niedrigeres Niveau zu entspannen oder welcher eine Kompressionseinrichtung enthält, mit dem ein auf niedrigerem Druckniveau zugeführtes Gas auf ein vorgebbares höheres Druckniveau angehoben werden kann. Das hierzu verwendete Gas kann Umgebungsluft sein oder aber ein Inertgas wie beispielsweise Stickstoff oder ein Edelgas, welches über eine Gaszufuhr 75 zugeführt wird.

Das so unter Druck gesetzte flüssige Medium 6 entweicht aus dem Reservoir 42 über eine Steigleitung 425. In der Steigleitung 425 finden sich optionale Einrichtungen zum Messen des Druckes 73 oder zur Messung des Durchflusses 74. In einigen Ausführungsformen können auch wie dargestellt Einrichtungen zur Druckmessung und zur Durchflussmessung gleichzeitig vorhanden sein. Die den Fluidführungseinrichtungen 3 tatsächlich zugeführte Flüssigkeitsmenge wird über ein Ventil 71 gesteuert oder geregelt. Das Ventil 71 kann beispielsweise ein Piezoventil sein, welches rasch anspricht und mit kurzen Regelzeiten angesteuert werden kann. Auch dies kann über die Steuer- oder Regeleinrichtung 7 erfolgen, welcher hierzu einen Mikroprozessor oder einen Mikrocontroller enthalten kann.

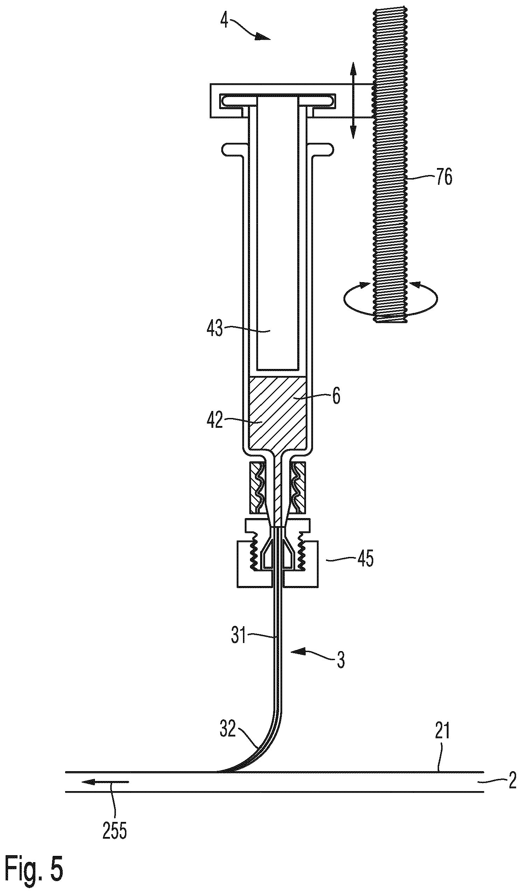

Anhand der Figur 5 wird eine dritte Ausführungsform der vorliegenden Erfindung erläutert. Gleiche Bestandteile sind wiederum mit gleichen Bezugszeichen versehen, sodass sich die folgende Beschreibung auf die wesentlichen Unterschiede beschränkt. In der dargestellten dritten Ausführungsform wird als Fluidfördereinrichtung eine Spritzenpumpe verwendet. Diese enthält ein Reservoir 42, welches mit einem Kolben 43 unter Druck gesetzt werden kann. Der Kolben 43 wird durch einen Linearantrieb maschinell bewegt, beispielsweise ein Spindelantrieb 76. Sofern die Spindel 76 mit einem Schrittmotor angetrieben wird, kann die Spritzenpumpe einen gleichmäßigen Fluidstrom des flüssigen Mediums 6 erzeugen.

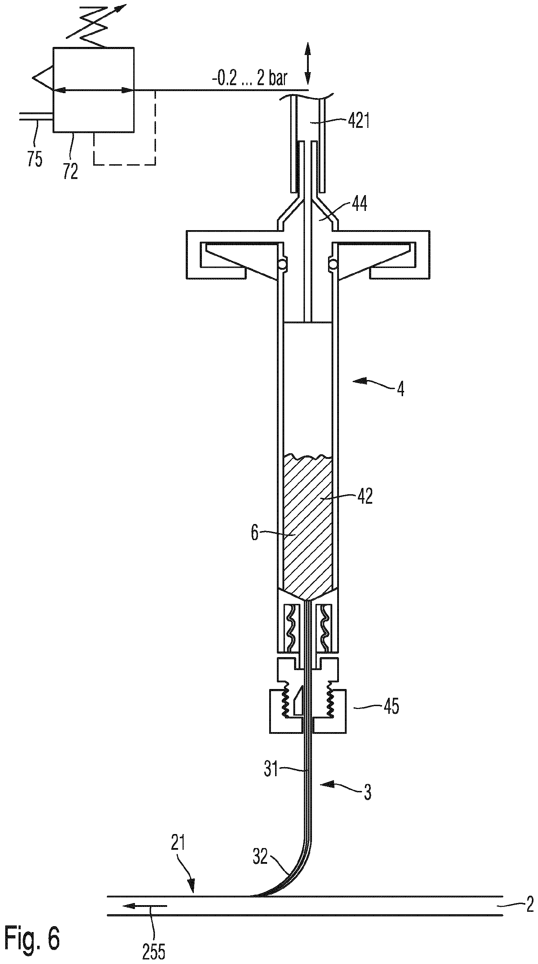

Anhand der Figur 6 wird eine vierte Ausführungsform der Erfindung erläutert. Die vierte Ausführungsform umfasst Elemente der vorstehend beschriebenen dritten und zweiten Ausführungsform der Erfindung. Auch in diesem Fall wird ein Spritzenkörper als Reservoir 42 verwendet, welcher das flüssige Medium 6 aufnimmt. Der zur Förderung des flüssigen Mediums 6 erforderliche Druck wird jedoch in der vierten Ausführungsform nicht über einen Kolben erzeugt, sondern durch Zufuhr eines Druckgases zu dem mit einem Verschluss 44 verschlossenen Reservoir 42.

Anstatt über eine Steigleitung tritt das flüssige Medium 6 über einen unten im Reservoir 42 angeordneten Ablauf aus, welcher wiederum unmittelbar mit der Fluidführungseinrichtung 6 verbunden ist.

Der dem Reservoir 42 zugeführte Gasdruck kann wiederum ein Inertgas oder Umgebungsluft enthalten, wobei die Gase über eine Gaszufuhr 75 zugeführt werden können. Zur Einstellung des benötigten Druckes kann ein elektrisches oder mechanisches Regelventil 72 vorhanden sein.

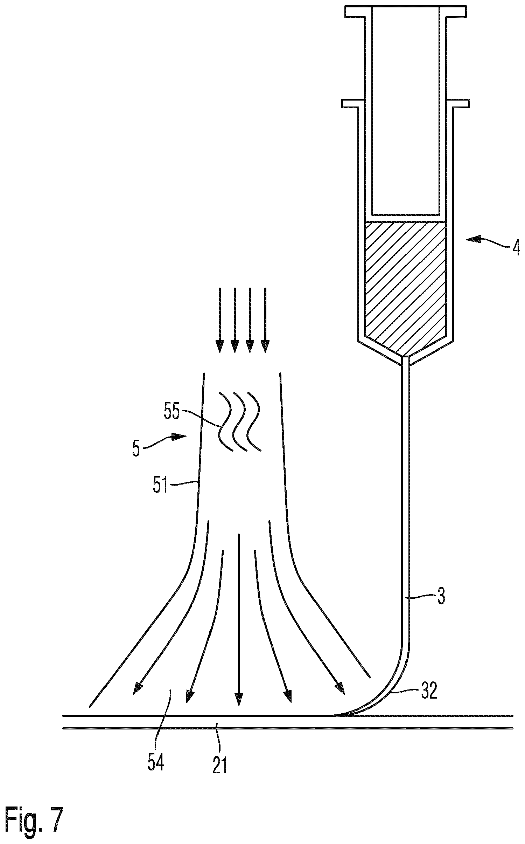

Anhand der Figur 7 wird erläutert, wie die erfindungsgemäße Vorrichtung durch eine Inertgaszufuhreinrichtung 5 ergänzt werden kann. Dargestellt ist in Figur 7 eine Fluidfördereinrichtung 4 in Form einer Spritze sowie eine Fluidführungseinrichtung 3 in Form einer Glaskapillare, deren zweiter Längsabschnitt 32 mit dem Substrat 2 in Kontakt steht. Selbstverständlich kann für die Fluidfördereinrichtung auch jede andere der vorstehend beschriebenen alternativen Ausführungsformen verwendet werden.

Die Inertgaszufuhreinrichtung 5 umfasst im Wesentlichen ein Zufuhrrohr 51, welches in eine Austrittsdüse 54 mündet. Das Inertgas, beispielsweise ein Edelgas oder Stickstoff, kann optional mit einer Heizeinrichtung 55 auf eine gewünschte Temperatur zwischen etwa 30°C und etwa 500°C erwärmt werden. Die Fluidführungseinrichtung 3 und die Austrittsdüse 54 wirken so zusammen, dass das Ende des zweiten Längsabschnittes 32 unterhalb der Austrittsdüse 54 bzw. im Austrittsbereich des Inertgases mündet und das flüssige Medium innerhalb des Inertgasstromes auf das Substrat 2 aufgebracht wird. Sofern der Inertgasstrom beheizt wird, kann dieser zur raschen Trocknung des flüssigen Mediums beitragen, sodass das flüssige Medium durch Vernetzung seiner Bestandteile aushärtet und/oder ein darin enthaltenes Lösemittel verdampft. Gleichzeitig verhindert das Inertgas eine unerwünschte Oxidation des flüssigen Mediums bzw. der auf der Oberfläche 21 verbleibenden Bestandteile des flüssigen Mediums.

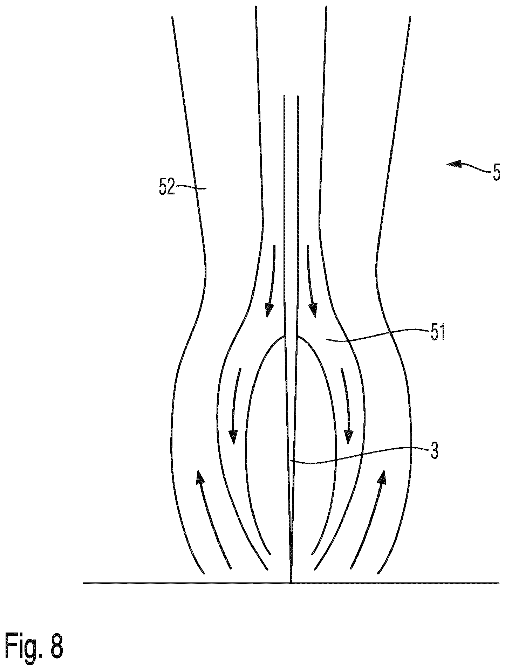

Anhand der Figur 8 wird eine alternative Inertgaszufuhreinrichtung gezeigt, welche eine Zufuhrleitung 51 aufweist, welche die Fluidführungseinrichtung 3 beziehungsweise einen Teil oder Längsabschnitt der Fluidführungseinrichtung 3 konzentrisch umgibt. Hierdurch wird das Inertgas gezielt dort zugeführt, wo das flüssige Medium aus der Fluidführungseinrichtung 3 austritt. Der Verbrauch des Inertgases kann dadurch reduziert sein.

Figur 8 zeigt weiterhin eine optionale Abfuhrleitung 52, welche die Zufuhrleitung 51 und die Fluidführungseinrichtung 3 konzentrisch umgibt. Dadurch kann das zugeführte Inertgas und/oder gasförmige Bestandteile des flüssigen Mediums 6 zumindest teilweise abgesaugt werden, sodass eine Kontamination der Umgebung durch toxische Medien vermieden oder reduziert werden kann.

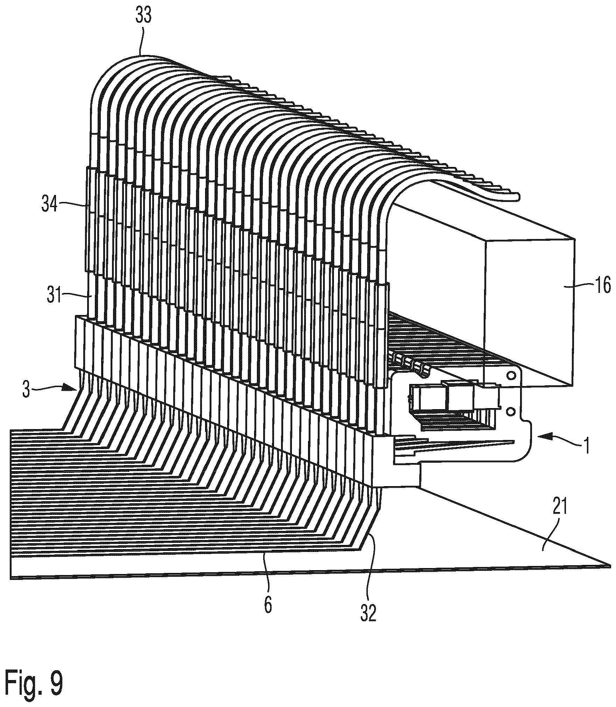

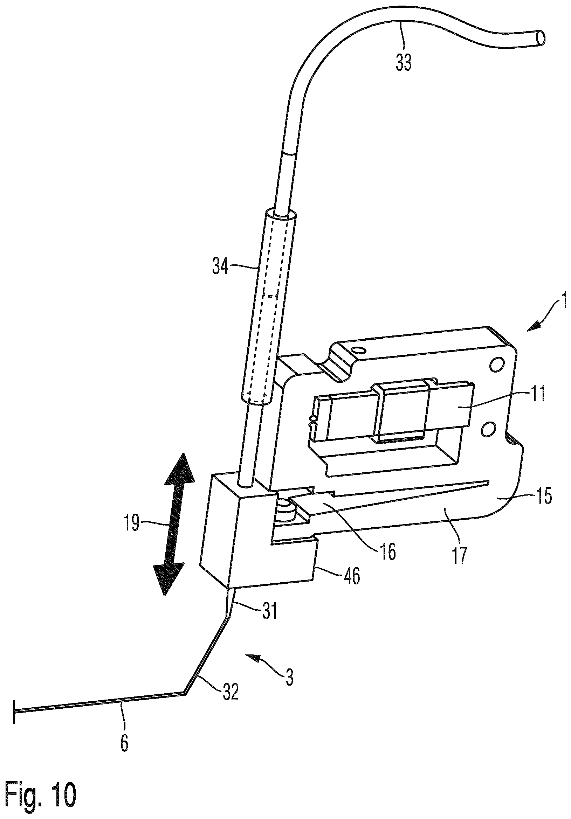

Anhand der Figuren 9 und 10 wird eine erste Ausführungsform einer Antriebseinrichtung näher erläutert. Dabei zeigt Figur 9 eine Mehrzahl von Fluidführungseinrichtungen 3, welche mit einer zugeordneten Antriebseinrichtung 1 auf einem gemeinsamen Träger 16 angeordnet sind. Im dargestellten Ausführungsbeispiel sind dreiunddreißig Fluidführungseinrichtungen 3 parallel angeordnet. In anderen Ausführungsformen der Erfindung kann die Anzahl der Fluidführungseinrichtungen 3 auch größer oder geringer sein und beispielsweise zwischen 1 und etwa 50 oder zwischen etwa 10 und etwa 100 betragen. Hierdurch können eine der Anzahl der Fluidführungseinrichtungen 3 entsprechende Anzahl an Linien aus dem flüssigen Medium 6 auf die Substratoberfläche 21 zeitgleich aufgebracht werden. Durch die Parallelisierung des Auftrags wird die Prozesszeit beim Aufbringen der Linien im gleichen Maße verkürzt, sodass flüssige Medien mit dem erfindungsgemäßen Verfahren auch kostengünstig auf Massenartikel aufgebracht werden können.

Dargestellt ist jeweils eine Fluidführungseinrichtung 3, welche eine Glaskapillare enthält mit einem ersten Längsabschnitt 31 mit vergleichsweise großem Querschnitt und einem zweiten Längsabschnitt 32, in welchem sich der Querschnitt auf den Enddurchmesser von beispielsweise etwa 0,5 µm bis etwa 10 µm verjüngt. Das flüssige Medium wird dem ersten Längsabschnitt 31 der Glaskapillare über Schlauchleitungen 33 zugeführt, welche mit einem Dicht- und Befestigungselement 34 befestigt sind und über eine nicht dargestellte Fluidfördereinrichtung mit dem flüssigem Medium versorgt werden.

Um eine Beschädigung der Fluidführungseinrichtung 3 bei Kontakt mit der Oberfläche 21 des Substrates 2 zu vermeiden, ist eine Antriebseinrichtung 1 vorgesehen, welche den Abstand mit großer Genauigkeit und/oder hoher Stellgeschwindigkeit steuern bzw. regeln kann.

Hierzu weist die Antriebseinrichtung 1 ein Grundelement 15 auf, welches einen Kragarm 17 aufweist, welcher durch einen Spalt 16 vom übrigen Grundelement 15 getrennt ist. Am Kragarm 17 ist eine Halteklammer 46 angeordnet, welche die Fluidführungseinrichtung 3 aufnimmt, beispielsweise durch Klemmung des ersten Längsabschnittes 31 einer Glaskapillare. Das Grundelement 15 kann aus einem Polymer oder einem Metall oder einer Legierung gefertigt sein.

Weiterhin enthält die Antriebseinrichtung 1 einen Piezostack 11, dessen Länge sich beim Anlegen einer elektrischen Spannung verändert. Dies induziert mechanische Spannungen im Grundelement 15, sodass sich durch dessen Verformung eine Bewegung des Kragarmes 17 ergibt. Die Fluidführungseinrichtung 3 durchfährt somit einen Stellweg 19, welcher beispielsweise zwischen etwa 100 µm bis etwa 300 µm betragen kann und welcher aufgrund der raschen Ansprechgeschwindigkeit des Piezostacks 11 mit einer Frequenz von etwa 200 Hz bis etwa 2000 Hz durchfahren werden kann. Die erfindungsgemäß vorgeschlagene Antriebseinrichtung kann somit den Abstand bzw. die Anpresskraft des zweiten Längsabschnittes 32 der Fluidführungseinrichtung 3 auf der Substratoberfläche 21 mit großer Genauigkeit und großer Geschwindigkeit variieren, sodass die Fluidführungseinrichtung 3 mit großer Präzision auf der Substratoberfläche 21 geführt werden kann, ohne dass die Substratoberfläche 21 oder die Fluidführungseinrichtung 3 beschädigt wird.

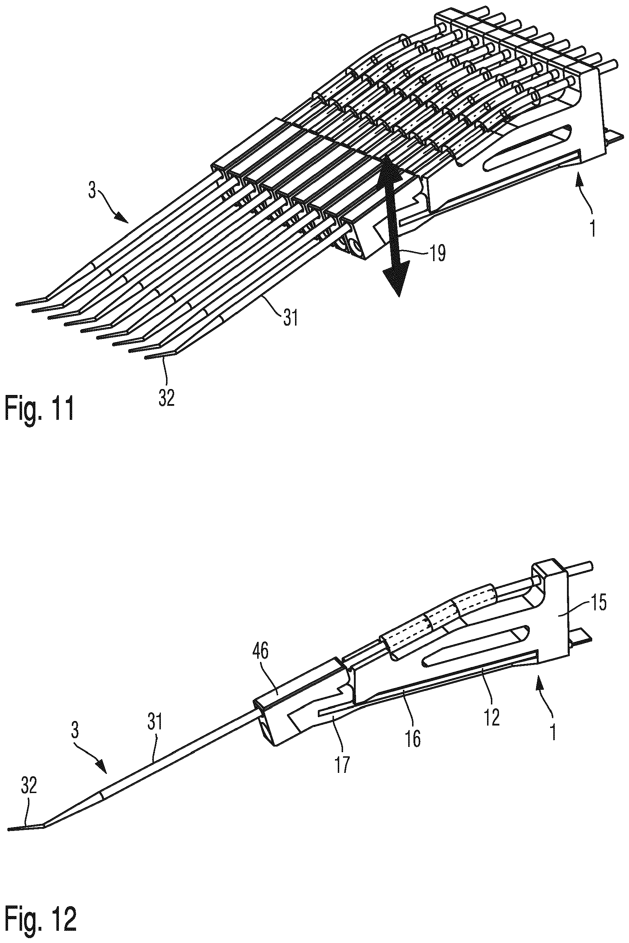

Anhand der Figuren 11 und 12 wird eine zweite Ausführungsform einer Antriebseinrichtung 1 näher erläutert. Auch die Antriebseinrichtung 1 enthält ein Grundelement 15, welcher zur Aufnahme der Fluidführungseinrichtung 3 vorgesehen ist. Auch in diesem Fall kann eine Glaskapillare mit ihrem ersten Längsabschnitt 31 in einer Klemmung 46 aufgenommen werden.

Die Grundelemente 15 weisen eine Form auf, welche eine endlose Anreihung einer Mehrzahl von Fluidführungseinrichtungen 3 ermöglicht, um die Abgabe des flüssigen Mediums zu Parallelisieren. In Figur 11 sind lediglich neun parallele Fluidführungseinrichtungen dargestellt. Wie jedoch vorstehend erläutert, kann diese Zahl auch größer oder geringer sein. Die Erfindung lehrt nicht die Verwendung von exakt neun Fluidführungseinrichtungen als Lösungsprinzip.

Im Unterschied zur ersten Ausführungsform der Antriebseinrichtung 1 wird in der zweiten Ausführungsform kein Piezostack 11 verwendet, welcher beim Anlegen einer Spannung seine Länge ändert, sondern einen Bendingpiezo 12, welcher sich nach Art eines Bimetalls bei Anlegen einer elektrischen Spannung nach oben oder unten verbiegt.

Der Bendingpiezo 12 ist unmittelbar im Spalt 16 des Grundelementes 15 angeordnet und wirkt damit unmittelbar auf den Kragarm 17 ein, welcher damit ebenfalls korrespondierend zur Bewegung des Bendingpiezo 12 nach oben oder unten entlang des Stellweges 19 ausgelenkt wird.

Nachfolgend soll die Erfindung anhand eines Ausführungsbeispiels näher erläutert werden. Dem Ausführungsbeispiel liegt die Erzeugung eines Vorderseitenkontaktes einer photovoltaischen Zelle zugrunde. Solche Vorderseitenkontakte werden als Linien- oder Gitterstruktur aufgebracht, um gleichzeitig Licht in das Halbleitermaterial der photovoltaischen Zelle einzukoppeln und den entstehenden elektrischen Strom abzuführen.

Zur Erzeugung des Vorderseitenkontaktes wird erfindungsgemäß eine wässrige Suspension verwendet, welche etwa 4 Vol.-% metallischer Nanopartikel enthält. Der Füllgrad des Metalls an der gesamten wässrigen Lösung beträgt somit etwa 50 Gew.-%. Die Nanopartikel können Silber enthalten oder daraus bestehen. Die Viskosität dieser Suspension liegt zwischen 5 mPa·s und 20 mPa·s. In bekannten Verfahren zur Erzeugung von Vorderseitenkontakten werden solche Suspensionen im InkJet-Verfahren aufgebracht, d.h. in Form kleiner Tröpfchen aus einem Druckkopf ausgestoßen und auf die Substratoberfläche aufgebracht. Die damit erzeugbaren Linien weisen eine Breite von mehr als 40 µm auf.

Die erfindungsgemäß verwendete Fluidführungseinrichtung enthält eine Glaskapillare mit einem Innendurchmesser von etwa 6 µm am Ende des zweiten Längsabschnittes 32. Eine solche Glaskapillare wird beispielsweise von der Fa. Eppendorf unter der Bestellnummer 5195000087 vertrieben. Der Innendurchmesser der Fluidführungseinrichtung 3 ist so gewählt, dass dieser größer ist als das etwa 5- bis 8-fache des durchschnittlichen Partikeldurchmesser der metallischen Nanopartikel in der verwendeten Suspension.

Durch eine Fluidfördereinrichtung wurde das flüssige Medium mit einem Druck von etwa 100 mbar aus den Fluidführungseinrichtungen ausgestoßen und auf eine photovoltaische Zelle mit etwa quadratischer Grundform und 156 mm Kantenlänge aufgebracht. Die Oberfläche war mit einer pyramidenförmigen Textur und einer Beschichtung versehen, welche Indium-ZinnOxid enthält. Für 80 Linien, welche jeweils über die gesamte Länge der Zelle verlaufen und jeweils eine Breite von 16 + 1 µm aufweisen, wurden insgesamt nur 0,3 + 0,1 mg der Suspension verbraucht. Nach Trocknen der Suspension hat diese einen höheren Silberanteil als übliche Siebdruckpasten, woraus eine bessere Leitfähigkeit als bei bekannten gedruckten Vorderseitenkontakten resultiert.

Es wurde somit gezeigt, dass mit dem erfindungsgemäßen Verfahren Vorderseitenkontakte schneller und mit geringerer Strukturgröße produziert werden können als im Siebdruck- oder InkJet-Verfahren, der Verbrauch der silberhaltigen Suspension reduziert ist und gleichwohl verbesserte Vorderseitenkontakte mit höherer elektrischer Leitfähigkeit erzeugt werden konnten.

Selbstverständlich ist die Erfindung nicht auf die dargestellten Ausführungsformen beschränkt. Die vorstehende Beschreibung ist daher nicht als beschränkend, sondern als erläuternd anzusehen. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Sofern die Ansprüche und die vorstehende Beschreibung "erste" und "zweite" Ausführungsformen definieren, so dient diese Bezeichnung der Unterscheidung zweier gleichartiger Ausführungsformen, ohne eine Rangfolge festzulegen. Der Schutzbereich des Patents wird durch die Patentansprüche bestimmt.

## Patentansprüche

1. Vorrichtung zum Aufbringen flüssiger Medien (6) auf eine Substratoberfläche (21), enthaltend zumindest eine Fluidführungseinrichtung (3) und zumindest eine Fluidfördereinrichtung (4) und zumindest eine Vorschubeinrichtung (25) zur Erzeugung einer Relativbewegung zumindest zwischen der Substratoberfläche (21) und einem Teil der Fluidführungseinrichtung (3), wobei
die Vorrichtung weiterhin zumindest eine Antriebseinrichtung (1) zur Veränderung des Abstandes zwischen der Substratoberfläche (21) und einem Teil eines zweiten Längsabschnittes (32) der Fluidführungseinrichtung (3) enthält, **dadurch gekennzeichnet, dass**
die Fluidführungseinrichtung (3) eine Kapillare enthält oder daraus besteht, welche einen Außendurchmesser von 25 µm oder weniger aufweist und die Fluidfördereinrichtung (4) dazu eingerichtet ist, das flüssige Medium mit einem Druck von etwa 100 mbar bis etwa 500 mbar oder von etwa 150 mbar bis etwa 300 mbar oder von etwa 500 mbar bis etwa 5000 mbar oder von etwa 1000 mbar bis etwa 2000 mbar von etwa 0 mbar bis etwa 100 mbar zu fördern.

2. Vorrichtung nach Anspruch 1, **dadurch gekennzeichnet, dass** die Fluidführungseinrichtung (3) eine Glaskapillare enthält oder daraus besteht und/oder
dass die Fluidführungseinrichtung (3) zumindest einen zweiten Längsabschnitt (32) aufweist, welcher einen Innendurchmesser von etwa 0,5 µm bis etwa 10 µm oder von etwa 2 µm bis etwa 8 µm oder von etwa 4 µm bis etwa 6 µm aufweist.

3. Vorrichtung nach einem der Ansprüche 1 bis 2, **dadurch gekennzeichnet, dass** die Fluidführungseinrichtung (3) eine Kapillare enthält oder daraus besteht, welche einen Außendurchmesser von 15 µm oder weniger aufweist oder dass die Fluidführungseinrichtung (3) eine Kapillare enthält oder daraus besteht, welche einen Außendurchmesser von 10 µm oder weniger aufweist oder
dass die Fluidführungseinrichtung (3) eine Kapillare enthält oder daraus besteht, welche einen Außendurchmesser von 7 µm oder weniger aufweist.

4. Vorrichtung nach einem der Ansprüche 1 bis 3, **dadurch gekennzeichnet, dass** die Kapillare einen ersten Längsabschnitt aufweist, welcher gegenüber einem zweiten Längsabschnitt der Kapillare angewinkelt bzw. gebogen ist oder
dass die Kapillare einen ersten Längsabschnitt und einen zweiten Längsabschnitt aufweist, welche einen Winkel von etwa 170° bis etwa 100° oder von etwa 160° bis etwa 110° oder von etwa 150° bis etwa 120° einschließen.

5. Vorrichtung nach einem der Ansprüche 1 bis 4, **dadurch gekennzeichnet, dass** die Fluidfördereinrichtung (4) eine Excenterschneckenpumpe (41) oder eine Kolbenpumpe (43, 76) enthält.

6. Vorrichtung nach einem der Ansprüche 1 bis 5, weiterhin enthaltend ein Ventil (71) zur Regelung des Volumenstroms des aus der Fluidführungseinrichtung (3) austretenden flüssigen Mediums (6).

7. Vorrichtung nach einem der Ansprüche 1 bis 6, weiterhin enthaltend eine Inertgaszufuhreinrichtung (5).

8. Vorrichtung nach Anspruch 7, **dadurch gekennzeichnet, dass** die Inertgaszufuhreinrichtung (5) eine Zufuhrleitung (51) aufweist, welche die Fluidführungseinrichtung (3) konzentrisch umgibt und eine optionale Abfuhrleitung (52) aufweist, welche die Zufuhrleitung (51) konzentrisch umgibt.

9. Verwendung einer Vorrichtung nach einem der Ansprüche 1 bis 8 zum Aufbringen einer Vorderseitenmetallisierung auf eine Solarzelle und/oder zum Aufbringen eines Ätzmittels und/oder zum Aufbringen eines pyrophoren Mediums und/oder zum Aufbringen lebender Zellen.

10. Verfahren zum Aufbringen flüssiger Medien (6) auf eine Substratoberfläche (21), bei welchem das flüssige Medium (6) mit zumindest einer Fluidfördereinrichtung (4) zu zumindest einer Fluidführungseinrichtung (3) gefördert wird und mit zumindest einer Vorschubeinrichtung (25) eine Relativbewegung zumindest zwischen der Substratoberfläche (21) und einem Teil der Fluidfördereinrichtung (4) erzeugt wird, wobei
durch zumindest eine Antriebseinrichtung (1) der Abstand zwischen der Substratoberfläche (21) und der Fluidführungseinrichtung (3) so variiert wird, dass zumindest ein Teil eines zweiten Längsabschnittes (32) in Kontakt mit der Substratoberfläche (21) steht,
**dadurch gekennzeichnet, dass**
die Fluidführungseinrichtung (3) eine Kapillare enthält oder daraus besteht, welche einen Außendurchmesser von 25 µm oder weniger aufweist und das flüssige Medium durch die Fluidfördereinrichtung (4) mit einem Druck von etwa 100 mbar bis etwa 500 mbar oder von etwa 150 mbar bis etwa 300 mbar oder von etwa 500 mbar bis etwa 5000 mbar oder von etwa 1000 mbar bis etwa 2000 mbar von etwa 0 mbar bis etwa 100 mbar gefördert wird.

11. Verfahren nach Anspruch 10, **dadurch gekennzeichnet, dass** die Fluidführungseinrichtung (3) eine Glaskapillare enthält oder daraus besteht und/oder
dass die Fluidführungseinrichtung (3) zumindest einen zweiten Längsabschnitt (32) aufweist, welcher einen Innendurchmesser von etwa 0,5 µm bis etwa 10 µm oder von etwa 2 µm bis etwa 8 µm oder von etwa 4 µm bis etwa 6 µm aufweist und/oder
dass die Fluidführungseinrichtung (3) eine Kapillare enthält oder daraus besteht, welche einen Außendurchmesser von 15 µm oder weniger aufweist oder dass die Fluidführungseinrichtung (3) eine Kapillare enthält oder daraus besteht, welche einen Außendurchmesser von 10 µm oder weniger aufweist oder
dass die Fluidführungseinrichtung (3) eine Kapillare enthält oder daraus besteht, welche einen Außendurchmesser von 7 µm oder weniger aufweist.

12. Verfahren nach einem der Ansprüche 10 bis 11, **dadurch gekennzeichnet, dass dadurch gekennzeichnet, dass** der Volumenstrom des aus der Fluidführungseinrichtung (3) austretenden flüssigen Mediums (6) durch ein Ventil (71) geregelt wird und/oder
dass der Volumenstrom des aus der Fluidführungseinrichtung (3) austretenden flüssigen Mediums (6) stetig aus der Kapillare austritt.

13. Verfahren nach einem der Ansprüche 10 bis 12, **dadurch gekennzeichnet, dass** das flüssige Medium (6) eine Viskosität von etwa 5 mPa·s bis etwa 200 mPa·s oder von etwa 5 mPa·s bis etwa 20 mPa·s aufweist und/oder dass das flüssige Medium (6) metallische Nanopartikel mit einer Konzentration von etwa 2 Vol% bis etwa 10 Vol% oder von etwa 2 Vol% bis etwa 6 Vol% von etwa 3 Vol% bis etwa 5 Vol% enthält.

14. Verfahren nach einem der Ansprüche 10 bis 13, **dadurch gekennzeichnet, dass** beim Aufsetzen der Fluidführungseinrichtung (3) auf die Substratoberfläche (21) eine Relativbewegung zwischen der Fluidführungseinrichtung (3) und der Substratoberfläche (21) erfolgt.

15. Verfahren nach einem der Ansprüche 10 bis 14, **dadurch gekennzeichnet, dass** die Kapillare oder der zweite Längsabschnitt der Kapillare einen Winkel von etwa 80° bis etwa 10° oder von etwa 70° bis etwa 20° oder von etwa 30° bis etwa 45° oder von etwa 20° bis etwa 10° zum Normalenvektor der Substratoberfläche einschließt.

## Claims

1. Device for applying liquid media (6) to a substrate surface (21), containing at least one fluid guiding apparatus (3) and at least one fluid conveying apparatus (4) and at least one advancing apparatus (25) for producing a relative movement at least between the substrate surface (21) and a part of the fluid guiding apparatus (3),
the device further containing at least one driving apparatus (1) for changing the distance between the substrate surface (21) and a part of a second longitudinal portion (32) of the fluid guiding apparatus (3), **characterized in that**
the fluid guiding apparatus (3) contains or consists of a capillary which has an outer diameter of 25 µm or less, and the fluid conveying apparatus (4) is designed to convey the liquid medium at a pressure from about 100 mbar to about 500 mbar, or from about 150 mbar to about 300 mbar, or from about 500 mbar to about 5000 mbar, or from about 1000 mbar to about 2000 mbar, from about 0 mbar to about 100 mbar.

2. Device according to claim 1, **characterized in that** the fluid guiding apparatus (3) contains or consists of a glass capillary and/or
**in that** the fluid guiding apparatus (3) includes at least a second longitudinal portion (32), which has an inner diameter from about 0.5 µm to about 10 µm, or from about 2 µm to about 8 µm, or from about 4 µm to about 6 µm.

3. Device according to any one of claims 1 to 2, **characterized in that**
the fluid guiding apparatus (3) contains or consists of a capillary which has an outer diameter of 15 µm or less, or
**in that** the fluid guiding apparatus (3) contains or consists of a capillary which has an outer diameter of 10 µm or less, or
**in that** the fluid guiding apparatus (3) contains or consists of a capillary which has an outer diameter of 7 µm or less.

4. Device according to any one of claims 1 to 3, **characterized in that** the capillary has a first longitudinal portion which is angled or bent with respect to a second longitudinal portion of the capillary, or in that the capillary has a first longitudinal portion and a second longitudinal portion that enclose an angle from about 170° to about 100°, or from about 160° to about 110°, or from about 150° to about 120°.

5. Device according to any one of claims 1 to 4, **characterized in that** the fluid conveying apparatus (4) contains an eccentric screw pump (41) or a piston pump (43, 76).

6. Device according to any one of claims 1 to 5, further containing a valve (71) for controlling the volume flow of the liquid medium (6) leaving the fluid guiding apparatus (3).

7. Device according to any one of claims 1 to 6, further containing an inert gas supply apparatus (5).

8. Device according to claim 7, **characterized in that** the inert gas supply apparatus (5) includes a supply line (51), which concentrically surrounds the fluid guiding apparatus (3) and has an optional discharge line (52), which concentrically surrounds the supply line (51).

9. Use of a device according to any one of claims 1 to 8 for applying a front side metallization to a solar cell and/or for applying an etchant and/or for applying a pyrophoric medium and/or for applying living cells.

10. Method for applying liquid media (6) to a substrate surface (21), in which the liquid medium (6) is conveyed by means of at least one fluid conveying apparatus (4) to at least one fluid guiding apparatus (3), and a relative movement at least between the substrate surface (21) and a part of the fluid conveying apparatus (4) is generated by means of at least one advancing apparatus (25),
the distance between the substrate surface (21) and the fluid guiding apparatus (3) being varied by means of at least one driving apparatus (1) in such a way that at least a part of a second longitudinal portion (32) is in contact with the substrate surface (21),
**characterized in that**
the fluid guiding apparatus (3) contains or consists of a capillary which has an outer diameter of 25 µm or less and the liquid medium is conveyed by the fluid conveying apparatus (4) at a pressure from about 100 mbar to about 500 mbar, or from about 150 mbar to about 300 mbar, or from about 500 mbar to about 5000 mbar, or from about 1000 mbar to about 2000 mbar, from about 0 mbar to about 100 mbar.

11. Method according to claim 10, **characterized in that** the fluid guiding apparatus (3) contains or consists of a glass capillary and/or in that the fluid guiding apparatus (3) includes at least a second longitudinal portion (32), which has an inner diameter from about 0.5 µm to about 10 µm, or from about 2 µm to about 8 µm, or from about 4 µm to about 6 µm and/or
**in that** the fluid guiding apparatus (3) contains or consists of a capillary which has an outer diameter of 15 µm or less, or
**in that** the fluid guiding apparatus (3) contains or consists of a capillary which has an outer diameter of 10 µm or less, or
**in that** the fluid guiding apparatus (3) contains or consists of a capillary which has an outer diameter of 7 µm or less.

12. Method according to any one of claims 10 to 11, **characterized in that** the volume flow of the liquid medium (6) leaving the fluid guiding apparatus (3) is controlled by a valve (71) and/or
**in that** the volume flow of the liquid medium (6) leaving the fluid guiding apparatus (3) constantly leaves the capillary.

13. Method according to any one of claims 10 to 12, **characterized in that** the liquid medium (6) has a viscosity from about 5 mPa·s to about 200 mPa·s, or from about 5 mPa·s to about 20 mPa·s and/or in that the liquid medium (6) contains metallic nanoparticles having a concentration from about 2 vol% to about 10 vol%, or from about 2 vol% to about 6 vol%, from about 3 vol% to about 5 vol%.

14. Method according to any one of claims 10 to 13, **characterized in that** when the fluid guiding apparatus (3) is placed on the substrate surface (21), a relative movement takes place between the fluid guiding apparatus (3) and the substrate surface (21).

15. Method according to any one of claims 10 to 14, **characterized in that** the capillary or the second longitudinal portion of the capillary encloses an angle from about 80° to about 10°, or from about 70° to about 20°, or from about 30° to about 45°, or from about 20° to about 10° to the normal vector of the substrate surface.

## Revendications

1. Dispositif pour appliquer des milieux liquides (6) sur une surface de substrat (21), comprenant au moins un moyen de guidage de fluide (3) et au moins un moyen de transport de fluide (4) et au moins un moyen d'avance (25) pour engendrer un mouvement relatif au moins entre la surface de substrat (21) et une partie du moyen de guidage de fluide (3), dans lequel
le dispositif comprend en outre au moins un moyen d'entraînement (1) pour modifier la distance entre la surface de substrat (21) et une partie d'un deuxième tronçon longitudinal (32) du moyen de guidage de fluide (3),
**caractérisé en ce que**
le moyen de guidage de fluide (3) comprend ou est constitué d'un capillaire qui présente un diamètre extérieur de 25 µm ou moins, et
le moyen de transport de fluide (4) est conçu pour transporter le milieu liquide à une pression d'environ 100 mbar à environ 500 mbar ou d'environ 150 mbar à environ 300 mbar ou d'environ 500 mbar à environ 5000 mbar ou d'environ 1000 mbar à environ 2000 mbar ou d'environ 0 mbar à environ 100 mbar.

2. Dispositif selon la revendication 1,
**caractérisé en ce que** le moyen de guidage de fluide (3) comprend ou est constitué d'un capillaire en verre, et/ou
**en ce que** le moyen de guidage de fluide (3) comprend au moins un deuxième tronçon longitudinal (32) qui présente un diamètre intérieur d'environ 0,5 µm à environ 10 µm ou d'environ 2 µm à environ 8 µm ou d'environ 4 µm à environ 6 µm.

3. Dispositif selon l'une des revendications 1 à 2,
**caractérisé en ce que** le moyen de guidage de fluide (3) comprend ou est constitué d'un capillaire qui présente un diamètre extérieur de 15 µm ou moins, ou
**en ce que** le moyen de guidage de fluide (3) comprend ou est constitué d'un capillaire qui présente un diamètre extérieur de 10 µm ou moins, ou **en ce que** le moyen de guidage de fluide (3) comprend ou est constitué d'un capillaire qui présente un diamètre extérieur de 7 µm ou moins.

4. Dispositif selon l'une des revendications 1 à 3,
**caractérisé en ce que** le capillaire comprend un premier tronçon longitudinal qui est incliné ou incurvé par rapport à un deuxième tronçon longitudinal du capillaire, ou
**en ce que** le capillaire comprend un premier tronçon longitudinal et un deuxième tronçon longitudinal qui forment un angle d'environ 170° à environ 100° ou d'environ 160° à environ 110° ou d'environ 150° à environ 120°.

5. Dispositif selon l'une des revendications 1 à 4,
**caractérisé en ce que** le moyen de transport de fluide (4) comprend une pompe à vis excentrée (41) ou une pompe à piston (43, 76).

6. Dispositif selon l'une des revendications 1 à 5,
comprenant en outre une vanne (71) de régulation du débit volumique du milieu liquide (6) sortant du moyen de guidage de fluide (3).

7. Dispositif selon l'une des revendications 1 à 6,
comprenant en outre un moyen d'alimentation en gaz inerte (5).

8. Dispositif selon la revendication 7,
**caractérisé en ce que** le moyen d'alimentation en gaz inerte (5) comprend un conduit d'alimentation (51) qui entoure concentriquement le moyen de guidage de fluide (3), et un conduit d'évacuation optionnel (52) qui entoure concentriquement le conduit d'alimentation (51).

9. Utilisation d'un dispositif selon l'une des revendications 1 à 8 pour appliquer une métallisation de face avant sur une cellule solaire et/ou pour appliquer un agent de gravure et/ou pour appliquer un milieu pyrophorique et/ou pour appliquer des cellules vivantes.

10. Procédé d'application de milieux liquides (6) sur une surface de substrat (21), dans lequel le milieu liquide (6) est transporté vers au moins un moyen de guidage de fluide (3) à l'aide d'au moins un moyen de transport de fluide (4), et un mouvement relatif au moins entre la surface de substrat (21) et une partie du moyen de transport de fluide (4) est engendré à l'aide d'au moins un moyen d'avance (25), et
à l'aide d'au moins un moyen d'entraînement (1), la distance entre la surface de substrat (21) et le moyen de guidage de fluide (3) est variée de telle sorte qu'au moins une partie d'un deuxième tronçon longitudinal (32) est en contact avec la surface de substrat (21),
**caractérisé en ce que** le moyen de guidage de fluide (3) comprend ou est constitué d'un capillaire qui présente un diamètre extérieur de 25 µm ou moins, et
le milieu liquide est transporté par le moyen de transport de fluide (4) à une pression d'environ 100 mbar à environ 500 mbar ou d'environ 150 mbar à environ 300 mbar ou d'environ 500 mbar à environ 5000 mbar ou d'environ 1000 mbar à environ 2000 mbar ou d'environ 0 mbar à environ 100 mbar.

11. Procédé selon la revendication 10,
**caractérisé en ce que** le moyen de guidage de fluide (3) comprend ou est constitué d'un capillaire en verre, et/ou
**en ce que** le moyen de guidage de fluide (3) comprend au moins un deuxième tronçon longitudinal (32) qui présente un diamètre intérieur d'environ 0,5 µm à environ 10 µm ou d'environ 2 µm à environ 8 µm ou d'environ 4 µm à environ 6 µm, et/ou
**en ce que** le moyen de guidage de fluide (3) comprend ou est constitué d'un capillaire qui présente un diamètre extérieur de 15 µm ou moins, ou en ce que le moyen de guidage de fluide (3) comprend ou est constitué d'un capillaire qui présente un diamètre extérieur de 10 µm ou moins, ou en ce que le moyen de guidage de fluide (3) comprend ou est constitué d'un capillaire qui présente un diamètre extérieur de 7 µm ou moins.

12. Procédé selon l'une des revendications 10 à 11,
**caractérisé en ce que** le débit volumique du milieu liquide (6) sortant du moyen de guidage de fluide (3) est régulé par une vanne (71), et/ou
**en ce que** le débit volumique du milieu liquide (6) sortant du moyen de guidage de fluide (3) sort en continu hors du capillaire.

13. Procédé selon l'une des revendications 10 à 12,
**caractérisé en ce que** le milieu liquide (6) présente une viscosité d'environ 5 mPa.s à environ 200 mPa.s ou d'environ 5 mPa.s à environ 20 mPa.s, et/ou
**en ce que** le milieu liquide (6) contient des nanoparticules métalliques ayant une concentration d'environ 2 % en volume à environ 10 % en volume ou d'environ 2 % en volume à environ 6 % en volume ou d'environ 3 % en volume à environ 5 % en volume.

14. Procédé selon l'une des revendications 10 à 13,
**caractérisé en ce que** lors de la mise en place du moyen de guidage de fluide (3) sur la surface de substrat (21), un mouvement relatif s'effectue entre le moyen de guidage de fluide (3) et la surface de substrat (21).

15. Procédé selon l'une des revendications 10 à 14,
**caractérisé en ce que** le capillaire ou le deuxième tronçon longitudinal du capillaire forme un angle d'environ 80° à environ 10° ou d'environ 70° à environ 20° ou d'environ 30° à environ 45° ou d'environ 20° à environ 10° par rapport au vecteur normal de la surface de substrat.
